# FASCICULE DE BREVET EUROPEEN

(11) **EP 0 556 115 B1**
(45) Date de publication et mention de la délivrance du brevet: **01.05.1996**
(21) Numéro de dépôt: 93400336.9
(22) Date de dépôt: 10.02.1993
(51) Int. Cl.: C23C 14/54, C23C 14/30

(54) **Dispositif de contrôle d'un flux de matière émise par une source d'évaporation sous vide**
Regelanordnung für den von einer Vakuumverdampfungsquelle abgegebenen Materialfluss
Device for control of material flow emitted by a vacuum evaporation source

(30) Priorité: 12.02.1992 FR 9201563
(43) Date de publication de la demande: 18.08.1993
(73) Titulaire: COMMISSARIAT A L'ENERGIE ATOMIQUE, F-75015 Paris (FR); ETAT FRANCAIS Représenté par le délégué général pour l'armement, F-00460 Armées (FR)
(72) Inventeur: Nouvelot, Luc, F-38400 Saint Martin d'Heres (FR); Perrin, Aimé, F-38330 Saint Ismier (FR)
(74) Mandataire: Ilgart, Jean-Christophe

(56) Documents cités:
- DE-A- 2 834 806
- US-A- 3 636 916

## Description

L'invention concerne un dispositif de contrôle du flux de matière émis par une source d'évaporation chauffée sous vide et est destinée à équiper une machine de revêtement ou de dépôt en couches minces par évaporation sous vide, et notamment une machine comportant plusieurs sources pour déposer un mélange de matériaux.

On éprouve fréquemment le souci de commander la vitesse du dépôt ou, dans le cas d'un dépôt simultané de plusieurs matériaux, de régler leur proportion quand on désire, entre autres exemples, régler l'indice de réfraction d'un filtre. Plusieurs méthodes existent. Dans l'une d'entre elles, on utilise pour chaque source une balance à quartz qu'on relie à un dispositif d'asservissement qui déduit la vitesse d'évaporation des indications de la balance et commande les variations de l'alimentation de la source pour obtenir le débit souhaité. Cet asservissement n'est pas toujours suffisant car le délai de réponse des sources aux variations d'alimentation n'est pas connu avec une grande précision. Selon une autre méthode, un des matériaux est extrait d'une source puis projeté vers l'objet à revêtir alors que l'autre est introduit dans l'enceinte où se trouve ledit objet par un autre moyen tel qu'un courant de gaz ou un bombardement d'ions. La première de ces façons de procéder (décrite dans « Codeposition of continuous composition rugate filters », par Gunning, Southwell et al., Rockwell International Science Center, Thousand Oaks, CA, USA, dans Applied Optics, vol.28, n°14, p.2945-2948; et dans « Rugate filters by lasers flash evaporation of SiOxNy on room temperature polycarbonate, par Bartholonew et al., IIT Research Institute, Chicago, IL, USA, dans Journal of Vacuum Science & Technology, vol.6, n°3, partie 2, p.1703-1707) n'est pas très précise à cause de l'inertie de l'écoulement des gaz et de leur insuffisante uniformité dans l'enceinte et la seconde (décrite dans « Near infrared Rugate filter fabrication by ion beam assisted deposition of Si(1-x) Nx films », par Donovan et al., US Naval Research Laboratory, Washington, DC, USA, Applied Optics, vol.28, p.2940-2944) nécessite un appareil particulier.

Une nouvelle solution est proposée avec le dispositif de l'invention, comme décrit dans des revendications 1-12. Elle consiste a utiliser des écrans ou caches munis d'ouvertures et qui défilent constamment devant la source de manière à présenter devant elle les ouvertures alternant avec des parties pleines, ce qu'on retrouve dans US-A-3 636 916; mais ici, le cache est mobile par rapport à la source d'une façon qui permet de faire varier le taux d'occultation de la source, c'est-à-dire la proportion du temps pendant lequel la source est recouverte par les parties pleines par rapport au temps total de défilement. Le débit de la source en direction de la pièce à recouvrir est dans ces conditions parfaitement défini. Le support sur lequel le cache est monté est de préférence mobile par rapport à celui de la source de façon qu'on puisse faire varier continûment le taux d'occultation en déplaçant le support. Il est d'ailleurs possible de rendre les variations du taux d'occultation proportionnelles au déplacement du support.

Une réalisation perfectionnée de ce dispositif comprend plusieurs sources et autant de caches que des moteurs font défiler. Tous les caches et les moteurs sont montés sur un support unique, et les caches sont conçus de façon que les déplacements du support par rapport à celui des sources font varier différemment le taux d'occultation de chaque source. On peut alors modifier librement la composition des dépôts réalisés.

L'invention va maintenant être décrite d'une manière plus concrète à l'aide des figures suivantes annexées à titre illustratif et non limitatif :
- la figure 1 représente une vue d'une machine de revêtement par évaporation sous vide utilisant le dispositif de l'invention, le cache étant un disque vu par la tranche ;
- la figure 2 est une vue d'une réalisation à deux sources fixes, les caches complémentaires, vus de face, étant montés sur un support animé d'un mouvement de translation ;
- la figure 3 est une vue d'une machine de revêtement par évaporation sous vide utilisant le dispositif de la figure 2 ;
- la figure 4 est une vue d'une réalisation à deux sources, les caches identiques vus de face étant chacun en rotation autour d'un axe fixe, et les deux sources étant animées d'un mouvement oscillant sur une trajectoire circulaire.

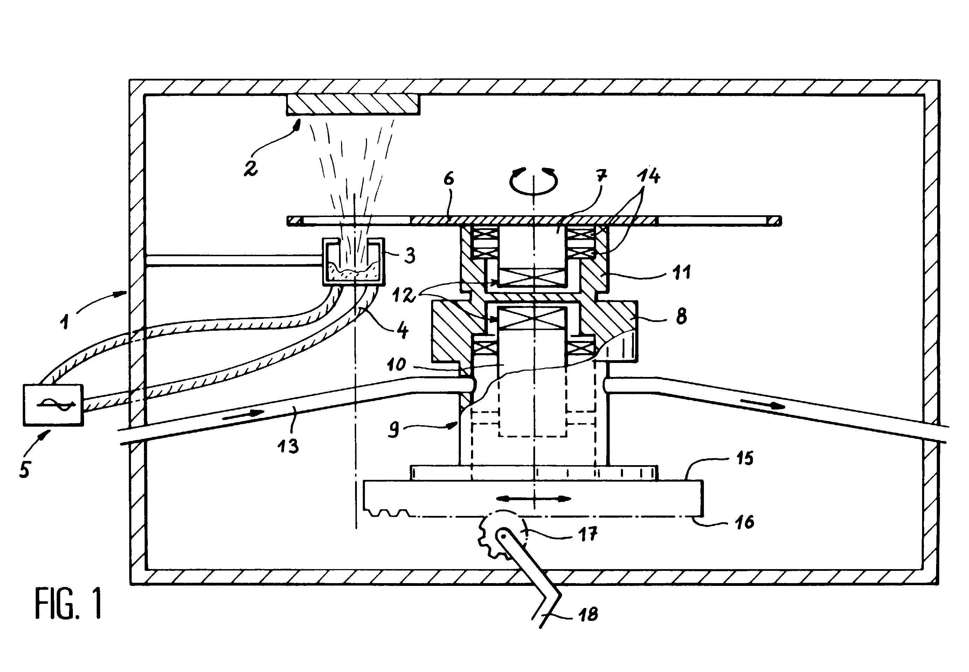

On passe maintenant au commentaire de la figure 1. La machine d'évaporation sous vide comprend tout d'abord une enceinte 1 dans laquelle est placé l'échantillon 2 à recouvrir d'un dépôt devant une source 3 soumise à une évaporation, alimentée par un câble électrique 4 et par un générateur de courant 5.

Un cache 6 est interposé entre l'échantillon 2 et la source 3, beaucoup plus près de celle-ci. Il s'agit d'un disque de faible épaisseur et de forme qu'on décrira plus loin. Il comporte en son centre un axe 7 qui le fait tournoyer et qui s'étend à quelque distance de la source 3. L'axe 7 est enfoncé dans un boîtier 8 qui contient un moteur électrique 9. Ce dernier comporte un arbre moteur 10 établi dans le prolongement de l'axe 7 et qui est séparé de lui par une cloison étanche 11 établie à travers l'intérieur du boîtier 8. Il n'y a donc aucune liaison mécanique entre l'arbre moteur 10 et l'axe 7, mais l'entraînement est assuré par des aimants permanents 12 situés sur leurs extrémités qui se font face et qui sont composés de groupes d'aimants établis en couronne et de pôles alternés disposés de manière à produire une force d'attraction tout en s'opposant aux rotations relatives.

Des canalisations 13 traversent l'enceinte 1, le boîtier 8 et aboutissent au moteur électrique 9. Elles contiennent des fils d'alimentation électrique et sont parcourues par un courant d'air de refroidissement. Le moteur électrique 9 est donc protégé de la température élevée, de l'ordre de 300°C, créée sur le masque 6 par la source 3. L'axe 7 tourne dans une partie ouverte du boîtier 8 par l'intermédiaire de roulements à billes 14 qui ne peuvent pas être lubrifiés par de la graisse et sont recouverts d'une mince couche de bisulfure de molybdène. Les billes sont en céramique. L'arbre moteur 10 peut être guidé par des roulements à billes ordinaires.

Le boîtier 8 est monté sur une table 15 faisant office de support et qui est mobile dans l'enceinte 1 vers la source 3 et en s'éloignant d'elle. On peut par exemple la pourvoir d'une crémaillère 16, qu'un pignon 17 commandé par une manivelle 18 qui s'étend à l'extérieur de l'enceinte 1 peut faire avancer. On voit que le cache 6 est déplacé devant la source 3 tout en demeurant dans un même plan, de manière à faire défiler devant elle une circonférence de diamètre choisi quand le moteur 9 est mis en marche et que l'axe 7 tourne.

Les moyens pour assurer l'étanchéité de l'enceinte 1 et pour créer le vide nécessaire au dépôt dans de bonnes conditions sont usuels et n'ont pas été représentés. On n'a pas non plus représenté ici les dispositifs qui permettent à la table 15 de coulisser et qui peuvent consister en des glissières ou des rails fixés à la paroi de l'enceinte 1.

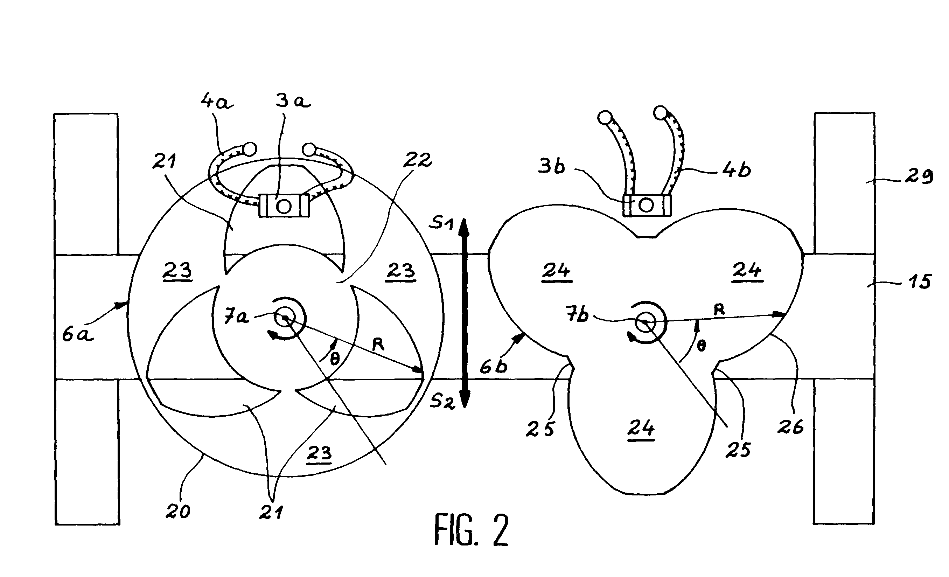

On passe maintenant au commentaire de la figure 2, qui illustre une machine à deux sources fixes 3a et 3b alimentées par des câbles électriques respectifs 4a et 4b et coopérant avec un cache respectif 6a ou 6b disposé sur un support 15 animé d'un mouvement de translation sur des rails 29 et tournant sous l'effet d'un axe 7a ou 7b. Deux formes principales de caches 6 ont été représentées : le premier cache 6a est un disque à contour extérieur circulaire 20 et muni de trois ouvertures 21 en forme de lobe dont l'extension d'arc diminue sans cesse vers la périphérie. Les ouvertures se rejoignent presque à une circonférence de rayon assez faible, mais s'interrompent ensuite vers l'intérieur de sorte que le premier cache 6a possède une surface centrale 22 de liaison à l'axe 7a. Trois parties pleines 23 s'étendent entre les ouvertures 21 et se rejoignent à la périphérie du premier cache 6a pour former le contour extérieur circulaire 20 tout en étant également d'une pièce avec la surface centrale 22.

Le second cache 6b a une forme différente puisqu'il comprend trois parties pleines 24 lobées semblables par leur forme aux ouvertures 21. Les parties pleines 24 sont réunies entre elles et s'étendent sur l'axe 7b ; des creux 25 entre les parties pleines 24 consécutives forment des ouvertures à la périphérie du second cache 6b, qui est cependant plein à l'intérieur de son contour 26. Les ouvertures 21 sont, de même que les parties pleines 24, à égale distance de l'axe 7 et régulièrement réparties sur la circonférence des caches 6. Les ouvertures 21 et les parties pleines 24 ont de plus des dimensions et des formes identiques.

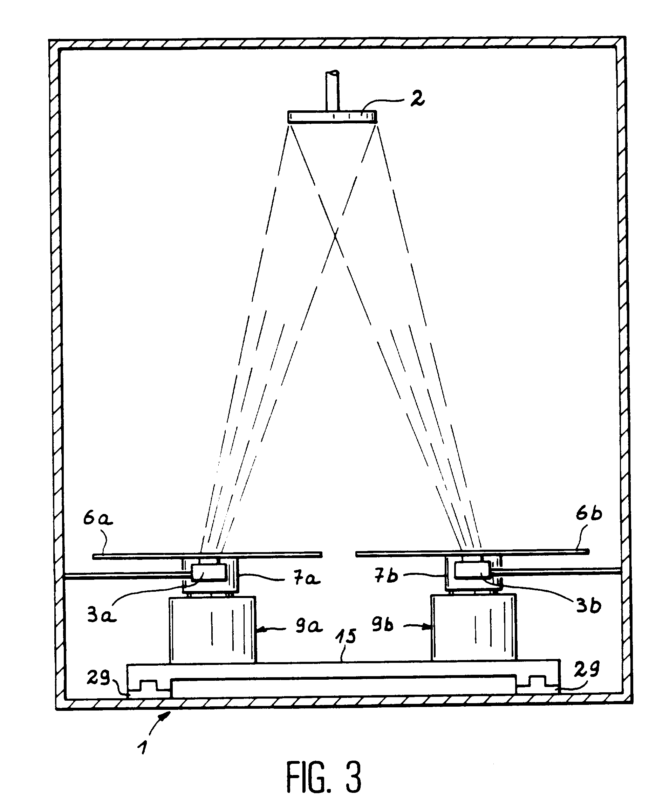

Les caches 6a et 6b de formes complémentaires tournent indépendamment dans le même plan ; ils peuvent être mus par des moteurs différents ou par un seul moteur muni de deux systèmes de transmission qui l'unissent aux deux axes 7a et 7b. Dans cette réalisation de l'invention, représentée aux figures 2 et 3, les moteurs 9a et 9b sont tous les deux fixés à la table 15. La table coulisse sur les rails 29. Les sources 3a et 3b sont immobiles. Un mouvement de la table dans le sens SI tend à rapprocher par un mouvement purement radial les sources 3a et 3b de l'axe de rotation de leur masque associé. La source 3a s'éloigne donc du contour circulaire extérieur 25 du masque 6a, ce qui augmente le temps de passage des ouvertures 21 devant la source 3a et diminue le temps de passage des parties pleines 23, c'est-à-dire le taux d'occultation de la source 3a. Quant à la source 3b, elle se rapproche dans le même temps et de la même quantité de l'axe 7b de sorte que le temps de défilement des parties pleines 24 et son taux d'occultation augmentent. Ce dispositif permet donc une variation opposée des taux d'occultation des sources 3a et 3b, dont la somme reste égale à 1 si les lobes des parties pleines 24 sont formés pour cela. Le mélange déposé sur l'objet à recouvrir a une composition variable et la vitesse de dépôt reste constante.

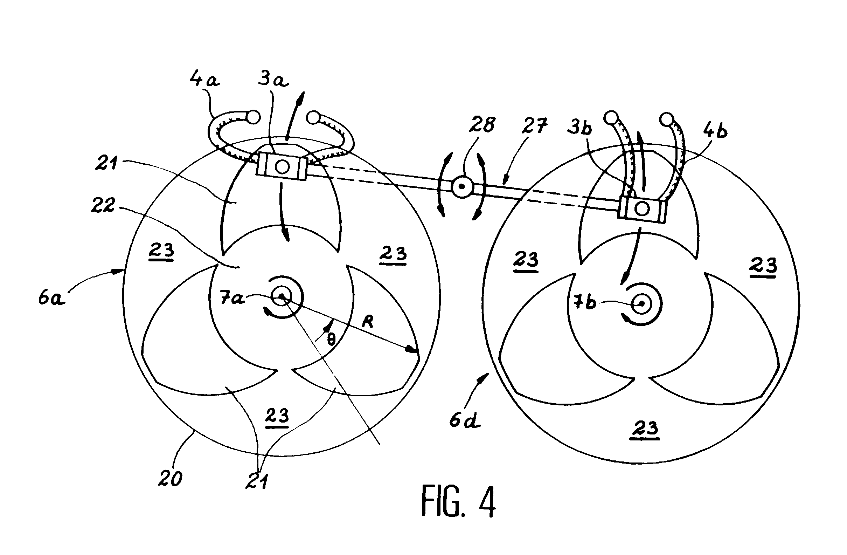

Dans une autre réalisation de l'invention représentée à la figure 4, les caches 6c et 6d sont identiques, possèdent la même forme que le cache 6a précédent, et sont à des emplacements fixes dans l'enceinte 1 sur laquelle ils sont supportés, mais les sources 3 sont accrochées aux extrémités des deux bras d'un balancier 27 qui s'étend sous les caches 6c et 6d et qui est mobile en son centre autour d'un pivot 28, parallèle aux axes 7, qui peut être mû de l'extérieur de l'enceinte 1 par une manivelle ou un dispositif analogue.

Ainsi, contrairement au cas précédent, les sources 3a et 3b ne sont pas fixes mais animées d'un mouvement oscillant sur une trajectoire circulaire autour de l'axe 28 du balancier 27.

Les déplacements du balancier 27 éloignent l'une des sources 3 de l'axe 7 du cache 6 associé et font l'inverse pour l'autre source 3, tout en maintenant les sources 3 à une distance constante des caches 6 : un mouvement dans le sens des aiguilles d'une montre du balancier 27 tend donc à rapprocher radialement la source 3a du contour extérieur circulaire 20 du premier cache 6c, ce qui diminue le temps de passage des ouvertures 21 devant la source 3a et augmente le temps de passage des parties pleines 23, c'est-à-dire le taux d'occultation de la source 3a. Quant à la source 3b, elle se rapproche radialement dans le même temps de l'axe 7b, et de la même quantité si l'axe 28 est équidistant des deux sources 3, de sorte que le temps de défilement des parties pleines 23 et son taux d'occultation diminuent. Ce dispositif permet donc une variation opposée des taux d'occultation des sources 3a et 3b, dont la somme peut rester égale si les lobes des parties pleines 23 sont formés pour cela. Ainsi quand les flux de matière issus des sources 6c et 6d sont choisis identiques, la vitesse de dépôt reste constante et le mélange déposé sur l'objet à recouvrir a une composition dont la variation est contrôlée par les conditions imposées par la forme des masques et le mouvement du balancier.

On comprend que des caches 6 d'autres formes ou placés à d'autres endroits permettraient de faire varier les taux d'occultation suivant d'autres principes, c'est-à-dire avec des variations différentes, selon le résultat recherché et en particulier la finesse du réglage de la composition ou de la vitesse de dépôt du mélange évaporé puis déposé. Ces résultats peuvent être atteints en disposant les sources 3 à l'extrémité de bras de longueurs différentes du balancier, en utilisant des caches avec des lobes ou des ouvertures de largeurs différentes ou en plaçant les caches des deux côtés du balancier. Il est d'ailleurs parfaitement possible d'utiliser des caches 6 et des axes 7 amovibles et qui peuvent être remplacés pour chaque utilisation de la machine.

Réciproquement, on pourrait fixer les sources 3 à l'enceinte 1 comme dans la réalisation précédente et disposer les caches 6 et leur moteur 9 sur le balancier.

Une machine de dépôt par évaporation sous vide de même type peut être équipée de la même manière de caches identiques présentant la même forme que le cache 6b précédent.

Les formes des lobes sont choisies avantageusement pour que les variations du taux d'occultation soient proportionnelles aux déplacements. Dans le cas de déplacements de translation entre la source 3 et le cache 6, on arrive à ce résultat si les limites des ouvertures ou des lobes sont des portions de spirales (d'équation R=aθ+b, où a et b sont des coefficients constants, avec les conventions de la figure 2 : R et θ sont des coordonnées polaires centrées sur l'axe 7).

On peut concevoir d'autres caches défilants que des disques tournants : des rubans sans fin ou soumis à un mouvement alternatif et comportant un contour en dents de scie seraient par exemple envisageables. Les avantages fondamentaux de l'invention, à savoir la facilité, la précision et la finesse du débit d'évaporation des sources vers l'objet à recouvrir seraient conservés.

## Revendications

1. Dispositif de contrôle d'un flux de matière émis par une source (3) montée sur un support, comprenant un cache constitué de parties pleines (23, 24) et d'ouvertures (21, 25), un moteur (9) faisant défiler le cache (6) devant la source (3), et un autre support (1, 15) sur lequel le cache et le moteur sont montés, caractérisé en ce qu'un des supports est mobile par rapport à l'autre de façon qu'on puisse faire varier le taux d'occultation de la source, défini comme la proportion, par rapport au temps total du défilement, du temps pendant lequel les parties pleines du cache s'étendent devant la source.

2. Dispositif suivant la revendication 1, caractérisé en ce que le cache est constitué d'un disque tournant autour d'un axe (7) excentré par rapport à la source, les ouvertures étant régulièrement réparties sur une circonférence du disque, identiques et disposées autour de l'axe.

3. Dispositif suivant la revendication 2, caractérisé en ce que les ouvertures sont séparées des parties pleines par des contours en forme de lobe.

4. Dispositif suivant la revendication 3, caractérisé en ce que les contours ont une forme telle que les variations du taux d'occultation soient proportionnelles aux déplacements du support.

5. Dispositif suivant la revendication 4, caractérisé en ce que le support est mobile en translation par rapport à la source et en ce que les contours ont une forme de spirale.

6. Dispositif suivant l'une quelconque des revendications 1 à 5, caractérisé en ce qu'il comprend plusieurs sources et autant de caches que des moteurs font défiler, un support unique sur lequel tous les caches et les moteurs sont montés et un autre support unique sur lequel toutes les sources sont montées, les caches étant conçus de façon que les déplacements du support mobile font varier différemment le taux d'occultation de chaque source.

7. Dispositif suivant la revendication 6, caractérisé en ce qu'un des supports est constitué par une table (15) mobile en translation sur des rails (29), l'autre des supports étant fixe.

8. Dispositif suivant la revendication 6, caractérisé en ce qu'un des supports est un balancier tournant (27) autour d'un axe (28), l'autre des supports étant fixe.

9. Dispositif suivant l'une quelconque des revendications 6 à 8, caractérisé en ce que les sources, les caches et les supports sont disposés de façon que toutes les sources sont soumises à des mouvements relatifs de même amplitude par rapport aux caches.

10. Dispositif suivant la revendication 9, dans lequel il y a deux sources qui sont respectivement associées à deux caches, caractérisé en ce que les caches sont identiques et les sources sont soumises à des déplacements radiaux et de sens opposés par rapport au cache associé.

11. Dispositif suivant la revendication 9, dans lequel il y a deux sources qui sont respectivement associées à deux caches, caractérisé en ce que les caches sont formés avec les ouvertures de l'un des caches identiques aux parties pleines de l'autre des caches et les sources sont soumises à des déplacements radiaux et de même sens par rapport au cache associé.

12. Machine de revêtement par évaporation sous vide, caractérisée en ce que l'enceinte à vide (1) contenant l'échantillon à revêtir (2) est équipée d'un dispositif de contrôle de flux suivant l'une quelconque des revendications 1 à 11.

## Patentansprüche

1. Regelanordnung eines Materialflusses, abgegeben von einer Quelle (3), angebracht an einem Träger, umfassend eine Abdeckung, gebildet durch volle Teile (23, 24) und Öffnungen (21, 25), einen Motor (9), der die Abdeckung (6) vorbeilaufen läßt vor der Quelle (3), und einen anderen Träger (1, 15), auf dem die Abdeckung und der Motor angebracht sind,
**dadurch gekennzeichnet**, daß einer der Träger beweglich ist in bezug auf den anderen, so daß man den Verdeckungsgrad der Quelle variieren kann, definiert als das Verhältnis - bezogen auf die Gesamtzeit des Vorbeilaufens - der Zeit, während der die vollen Teile der Abdeckung sich vor der Quelle erstrecken bzw. befinden.

2. Anordnung nach Anspruch 1, dadurch gekennzeichnet, daß die Abdeckung gebildet wird durch eine sich um eine Achse (7) drehende Scheibe, exzentrisch in bezug auf die Quelle, wobei die Öffnungen gleichmäßig über einen Umfang der Scheibe verteilt, identisch und um die Achse herum angeordnet sind.

3. Anordnung nach Anspruch 2, dadurch gekennzeichnet, daß die Öffnungen von den vollen Teilen getrennt sind durch lappenförmige Konturen.

4. Anordnung nach Anspruch 3, dadurch gekennzeichnet, daß die Konturen eine derartige Form haben, daß die Veränderungen des Abdeckungsgrades proportional sind zu den Verschiebungen des Trägers.

5. Anordnung nach Anspruch 4, dadurch gekennzeichnet, daß der Träger bezüglich der Quelle eine Translationsbewegung ausführt und daß die Konturen die Form einer Spirale aufweisen.

6. Anordnung nach einem der Ansprüche 1 bis 5, dadurch gekennzeichnet, daß sie mehrere Quellen aufweist und ebensoviele von Motoren bewegte Abdeckungen, einen einzigen Träger für das Anbringen aller Abdeckungen und Motoren und einen weiteren einzigen Träger für das Anbringen aller Quellen, wobei die Abdeckungen so beschaffen sind, daß die Verschiebungen des beweglichen Trägers den Abdeckungsgrad jeder Quelle variieren lassen.

7. Anordnung nach Anspruch 6, dadurch gekennzeichnet, daß einer der Träger durch einen Tisch (15) gebildet wird, der eine Translationsbewegung auf Schienen (29) ausführen kann, wobei der andere Träger ortsfest ist.

8. Anordnung nach Anspruch 6, dadurch gekennzeichnet, daß einer der Träger ein um eine Achse (28) drehbarer Schwinghebel (27) ist, wobei der andere Träger feststehend ist.

9. Anordnung nach einem der Ansprüche 6 bis 8, dadurch gekennzeichnet, daß die Quellen, die Abdeckungen und die Träger so angeordnet sind, daß alle Quellen Relativbewegungen gleichen Ausschlags in bezug auf die Abdeckungen ausgesetzt sind.

10. Anordnung nach Anspruch 9, bei der es zwei Quellen gibt, die jeweils zwei Abdeckungen zugeordnet sind, dadurch gekennzeichnet, daß die Abdeckungen identisch sind und die Quellen Verschiebungen ausgesetzt sind, radial und in entgegengesetzten Richtungen, bezogen auf die zugeordnete Abdeckung.

11. Anordnung nach Anspruch 9, dadurch gekennzeichnet, bei der es zwei Quellen gibt, die jeweils zwei Abdeckungen zugeordnet sind, dadurch gekennzeichnet, daß die Abdeckungen derart geformt sind, daß die Öffnungen der einen Abdeckung den vollen Teilen der anderen Abdeckung entsprechen und die Quellen Verschiebungen ausgesetzt sind, radial und in gleicher Richtung, bezogen auf die zugeordnete Abdeckung.

12. Apparat zur Beschichtung durch Verdampfung unter Vakuum, dadurch gekennzeichnet, das die das zu beschichtende Muster (2) enthaltende Vakuumzelle (1) ausgestattet ist mit einer Materialfluß-Regelanordnung nach einem der Ansprüche 1 bis 11.

## Claims

1. Apparatus for controlling a material flow emitted by a source (3) mounted on a support, comprising a cover constituted by solid portions (23,24) and openings (21,25), a motor (9) making the cover (6) move in front of the source (3) and by another support (1,15) on which are fitted the cover and the motor, characterized in that one of the supports is mobile with respect to the other, so that it is possible to vary the degree of hiding of the source, defined as the proportion, with respect to the total passage time, of the time during which the solid portions of the cover extend in front of the source.

2. Apparatus according to claim 1, characterized in that the cover is constituted by a disk rotating about a shaft (7) off-centered with respect to the source, the openings being regularly distributed on a circumference of the disk, are identical and positioned around the axis.

3. Apparatus according to claim 2, characterized in that the openings are separated from the solid portions by lobed contours.

4. Apparatus according to claim 3, characterized in that the contours have a shape such that the variations of the degree of hiding are proportional to the displacements of the support.

5. Apparatus according to claim 4, characterized in that the support is mobile in translation with respect to the source and in that the contours are spiral shaped.

6. Apparatus according to any one of the claims 1 to 5, characterized in that it comprises several sources and the same number of covers moved by motors, a single support on which are fitted all the covers and the motors and another single support on which all the sources are fitted, the covers being designed in such a way that the displacements of the mobile support lead to different variations of the degree of hiding of each source.

7. Apparatus according to claim 6, characterized in that one of the supports is constituted by a table (15) mobile in translation on rails (29), whilst the other support is fixed.

8. Apparatus according to claim 6, characterized in that one of the supports is a balance or beam (27) rotating about an axis (28), whilst the other support is fixed.

9. Apparatus according to any one of the claims 6 to 8, characterized in that the sources, the covers and the supports are arranged in such a way that all the sources are exposed to relative movements of the same amplitude with respect to the covers.

10. Apparatus according to claim 9 in which there are two sources, which are respectively associated with two covers, characterized in that the covers are identical and the sources are subject to radial displacements in opposite directions with respect to the associated cover.

11. Apparatus according to claim 9, in which there are two sources respectively associated with two covers, characterized in that the covers are formed with the openings of one of the covers identical to the solid parts of the other of the covers and the sources are exposed to radial displacements in the same direction relative to the associated cover.

12. Vacuum evaporation coating machine, characterized in that the vacuum enclosure (1) containing the sample (2) to be coated is equipped with a flow control apparatus according to any one of the claims 1 to 11.
